# EUROPEAN PATENT APPLICATION

(11) **EP 3 767 645 A1**
(43) Date of publication of application: **20.01.2021**
(21) Application number: 19766974.0
(22) Date of filing: 13.03.2019
(51) Int. Cl.: H01B 13/16, C25D 13/16, H01B 5/02, H01B 12/06, H01B 13/00

(54) **METHOD FOR MANUFACTURING INSULATED CONDUCTOR WIRE MATERIAL**

(30) Priority: 14.03.2018 JP 2018046985
(71) Applicant: Mitsubishi Materials Corporation, Tokyo 100-8117 (JP)
(72) Inventor: SAKURAI Hideaki, Naka-shi, Ibaraki 311-0102 (JP); KOMAI Eiji, Yokkaichi-shi, Mie 510-0841 (JP)
(74) Representative: Gille Hrabal
(86) International application number: PCT/JP2019/010284
(87) International publication number: WO 2019/177026

(57) **Abstract**

A method of manufacturing an insulated conductor wire material having a flat surface (12) with a groove (11,51) formed on the flat surface (13) and coated with an insulating film, comprising: an electrodeposition step of dipping the conductor wire material in an electrodeposition dispersion (62) and forming an insulating layer (13) on a surface of the conductor wire material; an electrodeposition dispersion removal step of removing the electrodeposition dispersion (62) on the insulating layer (13) by taking out the conductor wire material from the electrodeposition dispersion (62) and by blowing a gas on a side of the flat surface (62) with the groove (11, 51); a baking step of coating the conductor wire material with an insulating film by heating the conductor wire material with the insulating layer (13) formed thereon and by baking the insulating layer (13) onto the conductor wire material.

## Description

### [Technical Field]

The present invention relates to a method of manufacturing an insulated conductor wire material.

Priority is claimed on Japanese Patent Application No. 2018-046985 filed on March 14, 2018, the content of which is incorporated herein by reference.

### [Background Art]

As one of the insulated conductor wire materials, an insulated superconducting wire material in which the surface of the superconducting wire material is coated with an insulating film is known. This insulated superconducting wire material is used in fields such as a magnetic resonance imaging (MRI) device, a nuclear magnetic resonance (NMR) device, a particle accelerator, a linear motor car, and an electric power storage device. As the superconducting wire material, one having the structure (wire material-in-channel (WIC) structure), in which a superconducting multi-core wire material (occasionally, referred as a superconducting core material) made of a metal matrix and multiple threads of superconducting filaments is accommodated and fixed in a channel groove of a channel having a flat surface with the channel groove (occasionally, referred as a stabilizing material), is known. Further, as a superconducting wire material having the WIC structure, one having a configuration, in which the periphery of the superconducting multi-core wire material is coated with an electrical insulating layer, is known (Patent Literature 1).

The WIC structure superconducting wire material is capable of temporarily diverting the current flowing through the superconducting multi-core wire material to the channel when the superconducting state of a superconducting multi-core wire material wire is partially broken and a transition to the normal conducting state occurs. In the meantime, it becomes possible to return the superconducting multi-core wire material to the superconducting state. Therefore, in the WIC structure superconducting wire material, it is necessary to coat the entire superconducting wire material with an insulating film so that the current diverted to the channel does not leak to the outside.

In Patent Literature 2, a method, in which a superconducting wire material is produced by bonding a superconducting multi-core wire material and a channel with a solder followed by coating the surface of the superconducting wire material with an insulating resin, curing the resin and heating at temperature for duration time that the solder is not melted, is disclosed as a manufacturing method of the insulating superconducting wire material. In Patent Literature 2, methods, in which the superconducting wire material is passed through a tank holding an insulating coating material; and an insulating resin is subjected to extrusion molding, are described as methods of coating the surface of the superconducting wire material with an insulating resin.

### [Prior Art Literature]

### [Patent Literature]

Patent Literature 1: Japanese Patent Publication No. 2017-533579 (A)
Patent Literature 2: European Patent No. 2118941 (B), Specification

### [Summary of Invention]

### [Technical Problem]

As a method of coating the surface of the superconducting wire material with an insulating resin, the method described in Patent Literature 2, that is, a method of applying the insulating coating layer on the surface of the superconducting wire material by passing the superconducting wire material through a tank holding an insulating coating (dipping method) is an advantageous method because it can be carried out with relatively simple equipment. However, in the WIC-structured superconducting wire material, a groove is easily formed between the superconducting multi-core wire material and the channel groove of the channel. When an insulating coating layer is applied to the WIC structure superconducting wire material in which the groove is formed by the dipping method, the insulating coating is likely to accumulate in the groove of the superconducting wire material. In this case, there is a problem that the insulating coating layer applied on the groove of the superconducting wire material becomes thicker than the thickness of the insulating coating layer applied on a part other than the groove. When the thickness of the insulating coating layer is partially different, it is possible that the thickness of the insulating film obtained by heating the insulating coating layer varies, and the electrical insulating property of the insulating coating becomes uneven. When the insulating coating layer is heated, the solvent of the insulating coating material quickly vaporizes and the curing of the insulating resin progresses in the thin part of the insulating coating layer. On the other hand, vaporization of the solvent of the insulating coating material in the thick part of the insulating coating layer proceeds slowly. Thus, in a case of forced short-term vaporization, it is possible that foaming occurs in the insulating coating layer to cause formation of a large number of bubbles in the insulating coating film to deteriorate electrical insulation property of the insulating film.

Here, it is possible to use an electrodeposition method instead of the dipping method. The electrodeposition method is a method of immersing a superconducting wire material and an electrode in an electrodeposition dispersion, in which electrically insulating resin particles are dispersed, and applying a direct current voltage between the superconducting wire material and the electrode to obtain the surface of the superconducting wire material by attaching insulating resin particles to the surface of the superconducting wire material. The electrodeposition method is more advantageous than the dipping method in that an insulating layer having a uniform thickness can be formed regardless of the shape of the superconducting wire material. However, according to a study by the present inventors, in a conductor wire material having a flat surface on which a groove is formed like the WIC structure superconducting wire material, a depression is formed in the insulating layer along the groove of the conductor wire material. It was found that the electrodeposition dispersion easily accumulates in the depressions of the insulating layer of the conductor wire material in the wire material taken out from the electrodeposition dispersion. If the conductor wire material with the insulating layer is heated with the electrodeposition dispersion accumulated in the depressions of the insulating layer, the insulating layer foams when the solvent of the electrodeposition dispersion volatilizes, and a large number of bubbles are generated in the insulating film. In such a case, it is possible that the electric insulation property of the insulating film is deteriorated.

The present invention has been made in view of the above-mentioned circumstances, and an object thereof is to provide a method of manufacturing an insulating conductor wire material, in which an insulating film with a uniform thickness and few bubbles can be formed on a conductive wire material having a flat surface with a groove formed thereon by utilizing an electrodeposition method.

### [Solution to Problem]

The present invention has aspects indicated below to solve the above-described problems. An aspect of the present invention is a method of manufacturing an insulated conductor wire material (hereinafter, referred as "the method of manufacturing an insulated conductor wire material of the present invention") having a flat surface with a groove formed on the flat surface and coated with an insulating film, the method including: an electrodeposition step of dipping the conductor wire material in an electrodeposition dispersion and forming an insulating layer on a surface of the conductor wire material; an electrodeposition dispersion removal step of removing the electrodeposition dispersion attached on the insulating layer by taking out the conductor wire material with the insulating layer formed thereon from the electrodeposition dispersion and by blowing a gas on a side of the flat surface with the groove formed thereon of the conductor wire material; and a baking step of coating the conductor wire material with an insulating film by heating the conductor wire material with the insulating layer formed thereon, the electrodeposition dispersion being removed therefrom, and by baking the insulating layer onto the conductor wire material.

According to the method of producing an insulated conductor wire material of the present invention, in the electrodeposition dispersion removal step, a gas is blown on a side of the flat surface with the groove formed thereon of the conductor wire material, and the electrodeposition dispersion attached on the insulating layer is removed. Thus, foaming of the insulating layer due to vaporization of the solvent of the electrodeposition dispersion is less likely to occur in the baking step, and an insulating film having a uniform thickness and few bubbles can be formed.

In the method of producing an insulated conductor wire material of the present invention, the conductor wire material may be a superconducting wire material including a channel having a flat surface with a channel groove and a superconducting multi-core wire material accommodated and fixed in the channel groove of the channel, and the superconducting multi-core wire material may be made of a metal matrix and superconducting filaments.

In this case, the insulating film having a uniform thickness can be formed on the superconducting wire material having a flat surface with a groove formed thereon.

### [Advantageous Effects of Invention]

According to the present invention, it is possible to provide a method of manufacturing an insulating conductor wire material, in which an insulating film with a uniform thickness and few bubbles can be formed on a conductive wire material having a flat surface with a groove formed thereon by utilizing an electrodeposition method.

### [Brief Description of Drawings]

FIG. 1 is a cross-sectional view illustrating an example of a superconducting wire material used in a method of manufacturing an insulated superconducting wire material according to an embodiment of the present invention.
FIG. 2 is a cross-sectional view illustrating another example of the superconducting wire material used in the method of manufacturing an insulated superconducting wire material according to the embodiment of the present invention.
FIG. 3 is a schematic view showing an example of the configuration of an insulating film forming apparatus that can be advantageously used in the method of manufacturing an insulated superconducting wire material according to an embodiment of the present invention.
FIG. 4 is an enlarged view of the periphery of a blower of the insulating film forming apparatus shown in FIG. 3.
Fig. 5 is a sectional view taken along line IV-IV of FIG. 4.

### [Description of Embodiments]

Hereinafter, a method of manufacturing an insulated conductor wire material according to an embodiment of the present invention is described with reference to the accompanying drawings.

The method of manufacturing an insulated conductor wire material according to the present embodiment is a method of manufacturing an insulated conductor wire material having a conductor wire material having a flat surface on which a groove is formed, coated with an insulating film. Hereinafter, the present embodiment is described by taking a superconducting wire material having a WIC structure as an example.

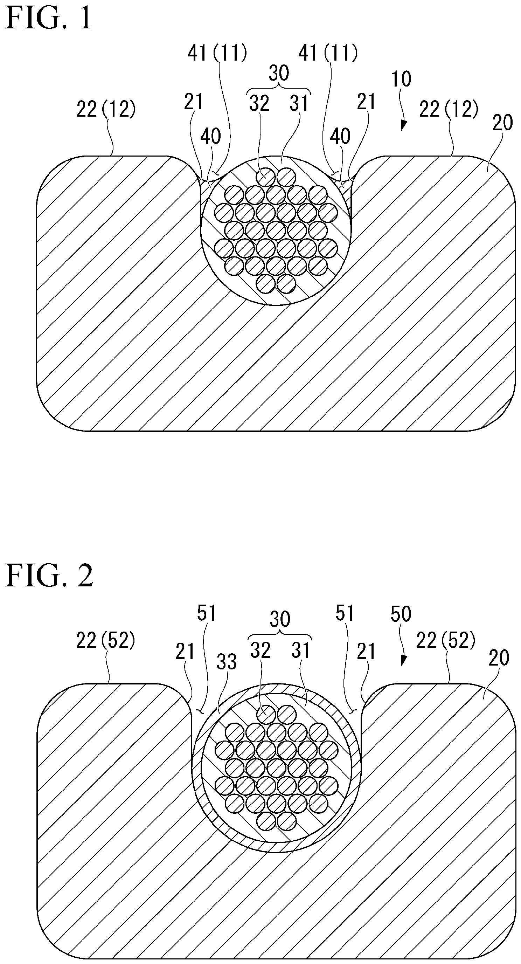

FIG. 1 is a cross-sectional view illustrating an example of a superconducting wire material used in the method of manufacturing an insulated superconducting wire material according to the embodiment of the present invention.

The superconducting wire material 10 shown in FIG. 1 includes a channel 20 having a flat surface 22 having a channel groove 21, and a superconducting multi-core wire material 30 accommodated and fixed in the channel groove 21. The cross-sectional shape of the superconducting wire material 10 is a substantially quadrangular shape with curvature at the corners. The superconducting multi-core wire material 30 includes a metal matrix 31 and superconducting filaments 32 embedded in the metal matrix 31. The channel groove 21 and the superconducting multi-core wire material 30 are fixed by soldering, and the solder 40 is filled between the inner wall of the channel groove 21 and the superconducting multi-core wire material 30. In the superconducting wire material 10 shown in FIG. 1, the cross-sectional shape of the superconducting multi-core wire material 30 is circular, but the cross-sectional shape of the superconducting multi-core wire material 30 is not particularly limited, and it may have a flat shape with curvature at the corners.

As the material of the channel 20, for example, copper, copper alloy, aluminum, or aluminum alloy can be used. As the material of the metal matrix 31 of the superconducting multi-core wire material 30, for example, copper, copper alloy, aluminum or aluminum alloy can be used. As a material of the superconducting filaments 32 of the superconducting multi-core wire material 30, for example, NbTi alloy or Nb3Sn can be used. As the material of the solder 40, an Sn-based solder can be used. As the Sn-based solder, for example, an alloy containing Sn and at least one metal selected from the group consisting of Sb, Ag, and Cu can be used.

In the superconducting wire material 10 in which the channel groove 21 and the superconducting multi-core wire material 30 are fixed by soldering, a depression 41 is formed on the surface of the solder 40. The depression 41 serves as the groove 11 of the superconducting wire material 10 and constitutes the superconducting wire material 10 having the flat surface 12 in which the groove 11 is formed. In the superconducting wire material 10 having such a structure, an insulating layer can be formed on the entire superconducting wire material 10 by the electrodeposition method. Accordingly, it becomes possible for the entire superconducting wire material 10 to be coated with an insulating film having a uniform thickness.

FIG. 2 is a cross-sectional view illustrating another example of the superconducting wire material used in the method of manufacturing an insulated superconducting wire material according to the embodiment of the present invention. The same components as those of the superconducting wire material 10 shown in FIG. 1 are designated by the same reference numerals and detailed description thereof is omitted.

The superconducting wire material 50 shown in FIG. 2 differs from the superconducting wire material 10 shown in FIG. 1 in that the periphery of the superconducting multi-core wire material 30 is coated with an electric insulating layer 33. For example, insulating resins such as polyvinylacetal resin, polyethyleneimine resin, polyethylene terephthalate resin, glass fiber, polyester resin, formalized-polyvinylalcohol resin, polyvinylalcohol resin, polyamideimide resin, and polyimide resin, can be used as the material of the electric insulating layer 33. These insulating resins may be used alone or in combination of two or more. The thickness of the electrically insulating layer 33 is, for example, in the range of 30 µm or more and 100 µm or less. The superconducting multi-core wire material 30 is fixed in the channel groove 21 by mechanical fastening.

In the superconducting wire material 50 in which the channel groove 21 and the superconducting multi-core wire material 30 are fixed by mechanical fastening, a gap is formed between the channel groove 21 and the superconducting multi-core wire material 30. The gap becomes the groove 51 of the superconducting wire material 50, and constitutes the superconducting wire material 10 having the flat surface 52 on which the groove 51 is formed. In the superconducting wire material 50 having such a structure, the insulating layer is formed on the surface of the channel 20 by the electrodeposition method, and the channel 20 is coated with the insulating film. Since the superconducting multi-core wire material 30 is coated with the electric insulating layer 33, the electric insulating layer 33 does not need to be coated with an insulating film.

The method of manufacturing an insulated superconducting wire material according to the present embodiment is a method of manufacturing an insulated superconducting wire material including: an electrodeposition step of dipping the superconducting wire material in an electrodeposition dispersion and forming an insulating layer on a surface of the superconducting wire material by an electrodeposition method; an electrodeposition dispersion removal step of removing the electrodeposition dispersion attached on the insulating layer by taking out the superconducting wire material with the insulating layer formed thereon from the electrodeposition dispersion and by blowing a gas on a side of the flat surface with the groove formed thereon of the superconducting wire material; and a baking step of coating the superconducting wire material with an insulating film by heating the superconducting wire material with the insulating layer formed thereon, the electrodeposition dispersion being removed therefrom, and by baking the insulating layer onto the superconducting wire material.

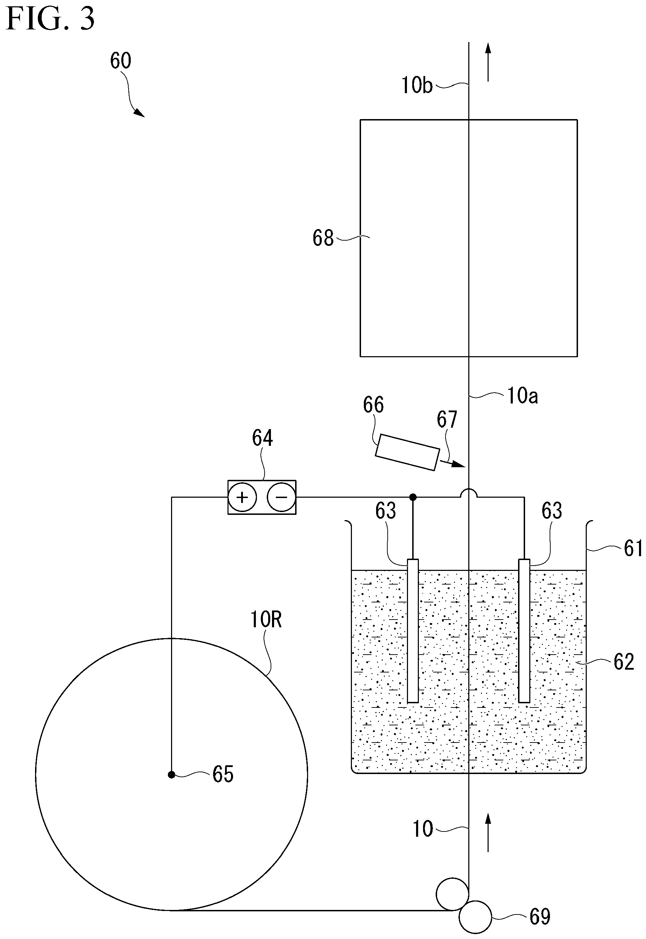

FIG. 3 is a schematic diagram showing an example of the configuration of an insulating film forming apparatus that can be advantageously used in the method of manufacturing an insulated superconducting wire material according to an embodiment of the present invention.

The insulating film forming apparatus 60 shown in FIG. 3 includes an electrodeposition dispersion tank 61, a blower 66, a heating furnace 68, and a conveying roller 69. The superconducting wire material 10 is arranged as a superconducting wire material roll 10R wound in a roll shape. The long superconducting wire material 10 unwound from the superconducting wire material roll 10R is conveyed by the conveying rollers 69 from bottom to top.

The electrodeposition dispersion tank 61 contains the electrodeposition dispersion 62. The electrodeposition dispersion 62 contains a solvent and insulating resin particles having a negative charge. For examples, a polar solvent such as N-methylpyrrolidone (NMP), N,N-dimethylformamide (DMF), N,N-dimethylacetamide (DMAc), 1,3 dimethylimidazolidinone, dimethylsulfoxide (DMSO), γ-butyrolactone (γ-BL) can be used. These solvents may be used alone or in combination of two or more. As a material for the insulating resin particles, for example, an insulating resin such as a polyimide resin, a polyamideimide resin, a polyesterimide resin, a polyester resin, or a polyurethane resin can be used. These insulating resins may be used alone or in combination of two or more. For example, the electrodeposition dispersion 62 is prepared by adding water, which is a poor solvent of the above-mentioned insulating resin, to an insulating resin solution, in which the above-mentioned insulating resin is dissolved in the above-mentioned solvent, and then mixing them, thereby precipitating the insulating resins and forming the insulating resin particles.

The insulating resin particles of the electrodeposition dispersion 62 preferably have an average particle diameter of 0.01 µm or more and 10 µm or less, and more preferably 0.05 µm or more and 1 µm or less, the diameter being measured by a laser diffraction method.

The content of the insulating resin particles in the electrodeposition dispersion 62 is preferably in the range of 1 % by mass or more and 20% by mass or less.

The electrodeposition dispersion tank 61 includes an electrode 63. The electrode 63 is connected to the negative terminal of the direct current supply 64. The positive terminal of the direct current source 64 is connected to the superconducting wire material roll 10R via the conductive wire 65.

Manufacturing of the insulating superconducting wire material using the insulating film forming apparatus 60 having such a structure is performed as follows, for example.

### (Electrodeposition step)

In the electrodeposition step, the direct current supply 64 is operated to apply a direct current voltage between the electrode 63 and the superconducting wire material 10 passing through the electrodeposition dispersion 62 in the electrodeposition dispersion tank 61, so that the insulating layer is formed on the surface of the superconducting wire material 10. By applying a direct current voltage, the superconducting wire material 10 acts as a positive electrode and the electrode 63 acts as a negative electrode, and the insulating resin particles having a negative charge in the electrodeposition dispersion 62 are electrodeposited on the surface of the superconducting wire material 10 and the insulating layer is formed. The voltage of the direct current voltage applied between the superconducting wire material 10 and the electrode 63 is preferably in the range of 1 V or more and 300 V or less. Further, the time for applying the direct current voltage between the superconducting wire material 10 and the electrode 63 is preferably within the range of 0.01 seconds to 30 seconds. By applying a direct current voltage between the superconducting wire material 10 and the electrode 63 under such conditions, an insulating layer having a uniform thickness can be formed on the surface of the superconducting wire material 10. The thickness of the insulating layer varies depending on the intended thickness of the insulating film, but is usually in the range of 5 µm or more and 60 µm or less.

### (Electrodeposition dispersion removal step)

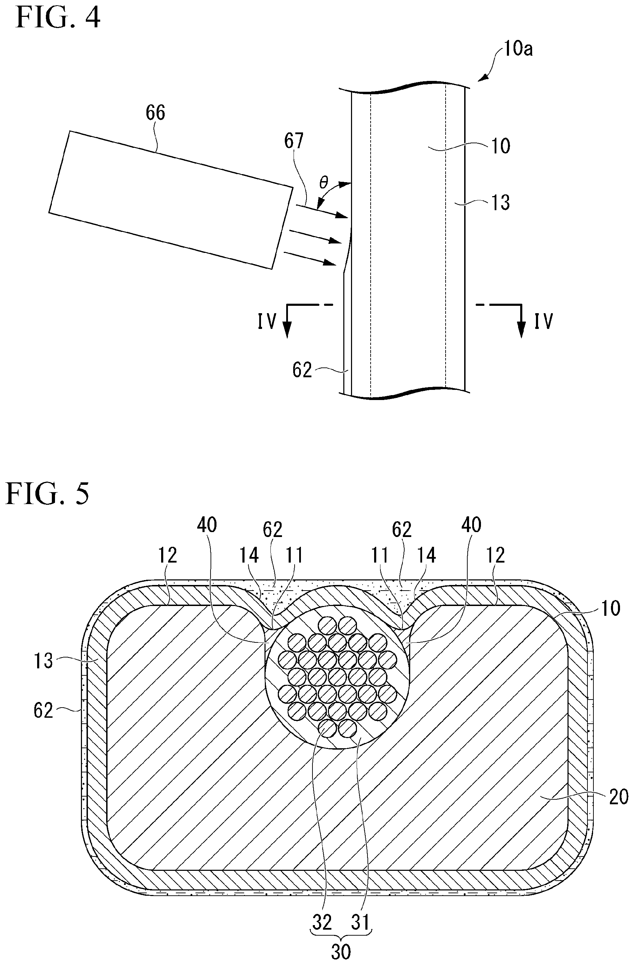

The electrodeposition dispersion removal step is described with reference to FIGS. 4 and 5. FIG. 4 is an enlarged view around the blower of the insulating film forming apparatus shown in FIG. 3. FIG. 5 is a sectional view taken along line IV-1V in FIG. 4.

In the electrodeposition dispersion removal step, the electrodeposition dispersion 62 attached on the insulating layer 13 is removed by taking out the superconducting wire material 10a with the insulating layer 13 formed thereon from the electrodeposition dispersion in the electrodeposition dispersion tank 61 and by blowing a gas 67 on a side of the flat surface 12 with the groove 11 formed thereon of the superconducting wire material 10 by using the blower 66.

As shown in FIG. 5, according to the electrodeposition method, the insulating layer 13 having a uniform thickness can be formed on the surface of the superconducting wire material 10. In superconducting wire material 10 having flat surface 12 in which groove 11 is formed, depression 14 is formed in insulating layer 13 along groove 11. The electrodeposition dispersion 62 is likely to be accumulated in the depression 14 of the insulating layer 13 due to the surface tension. Therefore, in the superconducting wire material 10a taken out from the electrodeposition dispersion 62, the electrodeposition dispersion is accumulated in the depression 14 of the insulating layer 13. When the superconducting wire material 10a is heated in a state where the electrodeposition dispersion 62 is accumulated in the depression 14 of the insulating layer 13, it is possible that the electric insulation property of the insulating film is deteriorated, since forming occurs in the insulation layer 13 during vaporization of the solvent of the electrodeposition dispersion 62; and a large number of bubbles are generated in the insulating film. Therefore, in this embodiment, before the baking step, the gas 67 is blown onto the surface of the superconducting wire material 10a using the blower 66 to remove the electrodeposition dispersion 62 attaching on the insulating layer 13.

As the gas 67 blown onto the surface of the superconducting wire material 10a, for example, air, nitrogen, carbon dioxide, or argon can be used. The flow velocity of the gas 67 varies depending on conditions such as the viscosity of the electrodeposition dispersion 62 for removal and the transport speed of the superconducting wire material 10a, but is preferably 30 m/sec or more. The angle at which the gas 67 is blown (θ in FIG. 4) is preferably in the range of 5 degrees to 90 degrees with respect to the surface of the superconducting wire material 10a.

### (Baking step)

In the baking step, the insulating layer 13 is baked onto the superconducting wire material 10 by heating the superconducting wire material 10a with the insulating layer 13 formed thereon, the electrodeposition dispersion 62 being removed therefrom by using the heating furnace 68. The heating temperature and time of the superconducting wire material 10a are not particularly limited as long as the insulating layer 13 is cured to form the insulating film and the solder 40 of the superconducting wire material 10 is not melted. The heating temperature, that is, the set temperature of the heating furnace 68 is, for example, in the range of 200°C to 450°C, and the heating time is, for example, in the range of 30 seconds to 240 seconds.

As described above, the insulating superconducting wire material 10b in which the superconducting wire material 10 is coated with the insulating film is manufactured. The final thickness of the insulating coating of the insulating superconducting wire material 10b is usually in the range of 3 µm or more and 60 µm or less.

According to the method of manufacturing an insulated superconducting wire material of the present embodiment configured as described above, in the electrodeposition dispersion removal step, the gas 67 is blown on the side of the flat surface 12 with the groove 11 formed thereon of the superconducting wire material 10. Since the electrodeposition dispersion 62 attached to the insulating layer 13 of the superconducting wire material 10a on which the insulating layer 13 is formed is removed, the electrodeposition dispersion 62 attached to the insulating layer 13 is reduced. Therefore, in the baking step, the insulating layer 13 is less likely to be foamed due to the vaporization of the solvent of the electrodeposition dispersion, and the insulating film having a uniform thickness and few bubbles can be formed.

Although the embodiment of the present invention has been described above, the present invention is not limited to these descriptions, and can be appropriately modified without departing from the technical concept of the present invention.

### [Industrial Applicability]

Provided is a method of manufacturing an insulated conductor wire material, which can form an insulating film having a uniform thickness and less bubbles on a conductor wire material having a flat surface on which a groove is formed, by using an electrodeposition method.

### [Reference Signs List]

- 10:: Superconducting wire material
- 10R:: Superconducting wire material roll
- 10a:: Superconducting wire material with insulating layer
- 10b:: Insulated superconducting wire material
- 11:: Groove
- 12:: Flat surface
- 13:: Insulating layer
- 20:: Channel
- 21:: Channel groove
- 22:: Flat surface
- 30:: Superconducting multi-core wire material
- 31:: Metal matrix
- 32:: Superconducting filament
- 33:: Electrical insulating layer
- 40:: Solder
- 41:: Depression
- 50:: Superconducting wire material
- 51:: Groove
- 60:: Insulating film forming equipment
- 61:: Electroplating liquid tank
- 62:: Electrodeposition dispersion
- 63:: Electrode
- 64:: Direct current power supply
- 65:: Conductive wire material
- 66:: Blower
- 67:: Gas
- 68:: Heating furnace
- 69:: Conveyor roller

## Claims

1. A method of manufacturing an insulated conductor wire material having a flat surface with a groove formed on the flat surface and coated with an insulating film, the method comprising:
an electrodeposition step of dipping the conductor wire material in an electrodeposition dispersion and forming an insulating layer on a surface of the conductor wire material;
an electrodeposition dispersion removal step of removing the electrodeposition dispersion attached on the insulating layer by taking out the conductor wire material with the insulating layer formed thereon from the electrodeposition dispersion and by blowing a gas on a side of the flat surface with the groove formed thereon of the conductor wire material; and
a baking step of coating the conductor wire material with an insulating film by heating the conductor wire material with the insulating layer formed thereon, the electrodeposition dispersion being removed therefrom, and by baking the insulating layer onto the conductor wire material.

2. The method of manufacturing an insulated conductor wire material according to claim 1, wherein
the conductor wire material is a superconducting wire material including a channel having a flat surface with a channel groove and a superconducting multi-core wire material accommodated and fixed in the channel groove of the channel, and
the superconducting multi-core wire material is made of a metal matrix and superconducting filaments.
